# EUROPÄISCHE PATENTSCHRIFT

(11) **EP 3 685 499 B1**
(45) Veröffentlichungstag und Bekanntmachung des Hinweises auf die Patenterteilung: **03.05.2023**
(21) Anmeldenummer: 18773979.2
(22) Anmeldetag: 19.09.2018
(51) Int. Cl.: H02M 1/12, H02J 3/01, H02J 3/38

(54) **WINDENERGIEANLAGE MIT LEISTUNGSABHÄNGIGER FILTEREINRICHTUNG**
WIND TURBINE WITH POWER-DEPENDENT FILTER DEVICE
INSTALLATION D'ÉNERGIE ÉOLIENNE À ÉQUIPEMENT DE FILTRE DÉPENDANT DE LA PUISSANCE

(30) Priorität: 19.09.2017 DE 102017121655
(43) Veröffentlichungstag der Anmeldung: 29.07.2020
(73) Patentinhaber: Wobben Properties GmbH, 26607 Aurich (DE)
(72) Erfinder: BERENTS, Gerd, 26605 Aurich (DE)
(74) Vertreter: Eisenführ Speiser
(86) Internationale Anmeldenummer: PCT/EP2018/075272
(87) Internationale Veröffentlichungsnummer: WO 2019/057736

(56) Entgegenhaltungen:
- EP-A1- 0 046 221
- EP-A1- 0 131 815
- EP-A1- 2 894 751
- US-A- 3 859 542

## Beschreibung

Die vorliegende Erfindung betrifft eine Windenergieanlage zum Erzeugen einer elektrischen Leistung zum Einspeisen in ein elektrisches Versorgungsnetz. Die vorliegende Erfindung betrifft auch ein Verfahren zur Auslegung einer Drosselspule zur Verwendung in einer Filtereinrichtung in einer Windenergieanlage. Zudem betrifft die vorliegende Erfindung ein Verfahren zum Umrüsten einer Windenergieanlage, durch Umrüsten einer Filtereinrichtung.

Moderne Windenergieanlagen können eine Vielzahl von Filtereinrichtungen aufweisen, die dazu vorgesehen sind, Oberschwingungen zu vermeiden oder zu verringern, wie beispielsweise ungewollte Oberschwingungen in Statorströmen oder Statorspannungen eines Generators. Solche Oberschwingungen können zwischen dem Generator und einem Gleichrichter durch das Gleichrichten entstehen. Um diesen Oberschwingungen zu begegnen, wird zwischen den Phasen des Generators, der mit dem Gleichrichter elektrisch verbunden ist, eine Filtereinrichtung eingesetzt.

Diese traditionellen Filtereinrichtungen sind vergleichsweise groß und haben dabei besonders große Filterdrosseln bzw. Filterinduktivitäten, die kostspielig sind und auch ein großes Gewicht haben können. Außerdem weisen sie durch ihren konstruktiven Aufbau für bestimmte Frequenzen einen Resonanzpunkt bzw. ein ungewünschtes Resonanzverhalten auf. Zudem verwenden traditionelle Filtereinrichtungen Dämpfungswiderstände, die für bestimmte Arbeitsbereiche große Verluste erzeugen können und ggf. mit einer aktiven Kühlung vor einer Überhitzung geschützt werden müssen.

Das Europäische Patentamt hat den nachfolgenden Stand der Technik recherchiert, nämlich EP 0131815 A1 und EP 2894751 A1. Das Dokument EP 0131815 A1 betrifft einen Wechselstrommaschinenantrieb mit einem frequenzvariablen Filter in Bypassschaltung zu einem Synchronmotor. Das Dokument EP 2894751 A1 betrifft einen statischen Blindleistungskompensator zur Regelung und automatischen Stabilisierung der Spannung und zur Kompensation der Blindleistung in Hochspannungsanlagen.

Aufgabe der vorliegenden Erfindung ist es somit, zumindest eines der o.g. Probleme zu adressieren. Insbesondere soll eine Lösung vorgeschlagen werden, die zumindest eine kompaktere und/oder günstigere Bauweise der Filtereinrichtung in der Windenergieanlage ermöglicht. Zumindest soll zu bisher bekannten Lösungen eine alternative Lösung vorgeschlagen werden.

Erfindungsgemäß wird somit eine Windenergieanlage nach Anspruch 1 vorgeschlagen. Diese ist zum Erzeugen einer elektrischen Leistung zum Einspeisen in ein elektrisches Versorgungsnetz vorgesehen. Somit umfasst die Windenergieanlage einen mehrphasigen Generator, insbesondere einen Synchrongenerator, zum Erzeugen elektrischer Leistung, wobei der Generator einen mehrphasigen Generatorstrom erzeugt. Dazu weist der Generator einen Generatorausgang zum Abgeben des mehrphasigen Generatorstroms auf. Der Generator erzeugt somit aus der mechanischen Energie des Windes einen mehrphasigen Generatorstrom, der an Generatoranschlüssen am Generatorausgang bereitgestellt werden kann.

Der Generator ist dabei in einem unteren und einem oberen Leistungsbereich betreibbar. Je nach vorherrschender Windgeschwindigkeit erzeugt die Windenergieanlage bzw. der mehrphasige Generator, der mit Rotorblättern der Windenergieanlage über eine mechanische Welle verbunden ist, unterschiedlich viel Leistung. Die Maximalleistung die ein Generator dabei dauerhaft erzeugen kann, ist meist seine Nennleistung, die als100 % angenommen werden kann.

Neben dem Generator, weist die Windenergieanlage zudem eine an den Generatorausgang angeschlossene Filtereinrichtung zum Erzeugen eines Filterstroms (I_{F}) zum Beeinflussen des Generatorstroms, insbesondere zum Reduzieren elektrischer Oberschwingungen des Generatorstroms auf. Die Filtereinrichtung ist somit elektrisch mit den Anschlüssen am Generatorsausgang verbunden. Die Filtereinrichtung erzeugt dabei wenigstens einen Filterstrom (I_{F}) an wenigstens einer Phase am Generatorausgang, insbesondere jeweils einen Filterstrom an jeder Phase, wobei der erzeugte Filterstrom von der erzeugten Leistung des Generators abhängig ist. Dabei erzeugt die Filtereinrichtung einen umso höheren Filterstrom, je höher die erzeugte Leistung des Generators ist. Die an den Generatorausgang angeschlossene Filtereinrichtung zum Erzeugen des Filterstroms umfasst dabei wenigstens eine Kapazität und wenigstens eine der Kapazität in Serie vorgeschaltete Drosselspule. Meist ist jeweils für ein dreiphasiges System eine dreiphasige Filtereinrichtung vorgesehen, die drei Filterdrosseln aufweist, eine je Phase, und drei Kapazitäten, die in einer Stern- oder Dreiecksschaltung verschaltet sein können.

Jede Filterdrossel ist dann zwischen einer Phase und einer Kapazität oder einem von drei Schaltungspunkten der Stern- bzw. Dreiecksschaltung verschaltet. Der Filterstrom hängt dann von der Dimensionierung der Filterdrosseln und der Kapazitäten ab. Um einen besonders hohen Filterstrom zu erreichen und auch thermisch zu ermöglichen, wurden die Filterdrosseln bisher sehr groß gewählt. Dabei beeinflussen die Kapazität und die vorgeschaltete Drosselspule den Filterstrom besonders in der Art eines LC-Filters.

Die Drosselspule ist außerdem durch einen Sättigungsstromwert gekennzeichnet, der eine Amplitude des Filterstroms bezeichnet, bei der die Drosselspule einen magnetischen Sättigungszustand aufweist. Eine Drosselspule bzw. allgemein eine Spule weist als eine dem Fachmann bekannte Kenngröße den sog. Sättigungsstromwert auf. Wird die Spule von einem Strom durchflossen der dem Sättigungsstromwert der Spule entspricht, oder darüber liegt, befindet sich die Drosselspule im Wesentlichen in einem sog. Sättigungszustand. Der Sättigungszustand entsteht im Wesentlichen dadurch, dass eine Spule einen materialspezifischen Höchstwert der Magnetisierung bzw. magnetische Flussdichte B aufweist, der durch ein Erhöhen des elektrischen Stroms durch die Spule nicht beliebig erhöht werden kann.

Dabei wird vorgeschlagen, dass die Filterdrosseln jeweils so gewählt werden, dass ihr Sättigungsstromwert unter einem vorbestimmten Filternennstrom der Filtereinrichtung liegt. Der Filternennstrom beschreibt dabei den Strom den die Filtereinrichtung dann erzeugt, wenn der Generator bei Nennleistung betrieben wird. In anderen Worten wird der Filternennstrom durch die Filtereinrichtung erzeugt, wenn die Nennleistung des Generators vorliegt. Ein Filternennstrom ist eine übliche Kenngröße eines Filters, wobei der Filter üblicherweise auf den Filternennstrom ausgelegt ist, sodass dieser im Normalbetrieb nicht überschritten wird.

Insbesondere wird die Drosselspule dabei so ausgewählt, dass diese bei einem Filterstrom unterhalb des Sättigungsstromwertes ein im Wesentlichen induktives Verhalten und bei einem Filterstrom oberhalb des Sättigungsstromwertes ein im wesentlichen ohmsches Verhalten aufweist.

Es wurde erfindungsgemäß erkannt, dass das spezielle Sättigungsverhalten einer Drosselspule genutzt werden kann, um in Abhängigkeit des sich ändernden Filterstroms unterschiedliche Verhalten einer Spule zu erreichen. Wird die Drosselspule von einem niedrigeren Filterstrom als der Sättigungsstromwert durchflossen, weist die Drosselspule ein induktives Verhalten auf, d.h. dass die Drosselspule eine messbare Induktivität aufweist, beispielsweise 100 µH. Dass die Drosselspule eine Induktivität aufweist, bedeutet somit, dass sie ein induktives Verhalten aufweist. Unterhalb des Sättigungsstromwerts weist die Drosselspule demnach noch eine Induktivität auf und der Sättigungszustand ist noch nicht erreicht. Ab Erreichen des Sättigungsstromwertes, der im vorgeschlagenen Fall unter einem vorbestimmten Filternennstrom der Filtereinrichtung liegt, sinkt bei einer Zunahme des Filterstroms die Induktivität der Drosselspule ab, bspw. auf weniger als 10 µH. Somit weist die Drosselspule unterhalb des Sättigungsstromwertes ein im Wesentlichen induktives Verhalten auf - im Beispiel 100 µH - und oberhalb des Sättigungsstromwertes dann abnehmend nur noch wenige µH auf, z.B. 10µH. Dabei ist die Drosselspule so ausgelegt, dass ihr Sättigungswert unter dem vorbestimmten Filternennstrom liegt. Demnach hat die Drosselspule im genannten Beispiel bei einem Filterstrom unterhalb des Sättigungsstromwertes ein im Wesentlichen induktives Verhalten und bei einem Filterstrom oberhalb des Sättigungsstromwertes ein im Wesentlichen ohmsches Verhalten, da dort die Induktivität abgesunken ist.

Dem Fachmann ist dabei verständlich, dass der Übergang vom induktiven Verhalten zum ohmschen Verhalten kein scharfer Übergang ist, sondern die Induktivität mit zunehmendem Strom abfällt. Ist bspw. eine Sättigungsdrossel auf einen Sättigungsstromwert vom 30 Ampere ausgelegt, könnte die Sättigungsdrossel eine Induktivität von 100 µH aufweisen und erst ab etwa 80 Ampere soweit abgefallen sein, dass die Induktivität kleiner als 10 µH ist. Im genannten Beispiel sinkt die Induktivität somit in einem Übergangsbereich um 1,8 µH pro Ampere ab.

Somit wird vorgeschlagen, das Sättigungsverhalten der Drosselspule so zu nutzen, dass bei niedrigen Filterströmen die Spule im Wesentlichen ein induktives Verhalten aufweist und bei Filterströmen oberhalb des Sättigungswertes der Drosselspule im Wesentlichen ein ohmsches Verhalten bzw. eine sehr niedrige Induktivität aufweist.

Es wurde erkannt, dass signifikante elektrische Schwingungen bei geringen Leistungen des Generators auftreten können, d.h. bei niedrigen Generatorströmen. Besonders in der Nähe eines Nulldurchgangs eines Generatorstroms bzw. Phasenstroms können ungewünschte Schwingungen auftreten, die insbesondere durch den Gleichrichter geprägt werden. Diese werden beispielsweise durch unsauberes Durchsteuern des Gleichrichters im unteren Leistungsbereich verursacht, wenn der kapazitive Anteil des Filters keine Dämpfung in Form einer Reiheninduktivität aufweist.

Somit soll die Drosselspule besonders für niedrige Generatorströme ein im Wesentlichen induktives Verhalten zur Dämpfung der auftretenden Schwingungen aufweisen. Dies wird durch das induktive Verhalten im unteren Leistungsbereich der Drosselspule erreicht. Bei höheren erzeugten Leistungen bzw. Generatorströmen treten keine signifikanten Schwingungen mehr auf, so dass dort im Wesentlichen kein induktives Verhalten der Drosselspule benötigt wird. Durch die geschickte Auslegung der Drosselspule weist die Drosselspule dann ein im Wesentlichen ohmsches Verhalten für höhere Generatorströme bzw. Generatorleistungen auf. Besonders vorteilhaft an der Verwendung einer Spule mit dem beschriebenen leistungsabhängigen Verhalten ist, dass die Spule durch ihr ohmsches Verhalten im oberen Leistungsbereich außerdem den Resonanzpunkt der Filtereinrichtung verschiebt. Durch die gewollte Sättigung der Drossel verringert sich der Induktivitätswert und verschiebt somit den Resonanzpunkt der Filtereinrichtung, die aus LCR-Komponenten aufgebaut ist, in höhere Frequenzbereiche. In den höheren Frequenzbereichen treten nur noch vernachlässigbare Oberwellen auf, sodass es zu keiner Stromüberhöhung in einem Resonanzpunkt kommt. Konventionelle Filtereinrichtungen weisen hingegen einen festen Resonanzpunkt auf, sodass es zu einer ungewollten Stromerhöhung im Resonanzpunkt kommt, wenn der Filterstrom Frequenzanteile aufweist, die im Bereich des Resonanzpunkts liegen. Dieser ungewünschten Stromerhöhung wurde bisher durch zusätzliche Dämpfungswiderständen begegnet.

In einer besonderen Ausführungsform wird vorgeschlagen, das gesamte Intervall der Generatorleistung von 0 bis 100 % in einen unteren und in einen oberen Leistungsbereich zu unterteilen.

Gemäß der besonderen Ausführungsform wird der Generator dabei im unteren Leistungsbereich betrieben, wenn die erzeugte Leistung des Generators unter einem Leistungsgrenzwert liegt. Und es wird der Generator im oberen Leistungsbereich betrieben, wenn die erzeugte Leistung des Generators dem vorbestimmten Leistungsgrenzwert entspricht oder diesen überschreitet.

Wird bspw. ein vorbestimmter Leistungsgrenzwert von 10 % der Nennleistung des Generators angenommen, beschreibt der untere Leistungsbereich den Leistungsbereich des Generators von 0 bis ausschließlich 10 %. Der obere Leistungsbereich läge in diesem Beispiel dann von einschließlich 10% bis 100 % der Nennleistung. Der vorbestimmte Leistungsgrenzwert ist somit als ein Schwellenwert zu verstehen, der auf die Maximalleistung des Generators prozentual bezogen sein kann. Der vorbestimmte Leistungsgrenzwert kann zudem auch ein vorbestimmter Stromsollwert sein, der die maximale Amplitude von wenigstens einem der Generatorströme beschreibt. Wenn der Generator bspw. einen maximalen Generatorstrom von 450 A als Spitzenwert bei einer Nennleistung von 100% erzeugt, könnte ein vorbestimmter Leistungsgrenzwert in diesem Falle auch ein Stromgrenzwert sein. Ein vorbestimmter Leistungsgrenzwert von 45A (10% von 450A) würde in diesem Fall die beiden Leistungsbereiche so definieren, dass der untere Leistungsbereich von 0A bis 45A und der obere Leistungsbereich von 45A bis 450A vorliegt.

Gemäß einer weiteren Ausführungsform wird vorgeschlagen, dass die Drosselspule bei einem Filterstrom unterhalb des Sättigungsstromwertes ein im Wesentlichen induktives Verhalten und bei einem Filterstrom oberhalb des Sättigungsstromwertes ein im Wesentlichen ohmsches Verhalten aufweist.

So wird vorteilhafterweise erreicht, dass bei niedrigen Filterströmen, insbesondere im Bereich von Nulldurchgängen des Generatorstroms, ein induktives Verhalten der Drosselspule vorliegt und die Spule dadurch elektrische Schwingungen des Generatorstroms reduziert. Für größere Generatorströme oberhalb des Sättigungsstroms verhält sich die Spule dann nur noch im Wesentlichen wie ein Widerstand.

Vorzugsweise wird vorgeschlagen, dass die Drosselspule dazu eingerichtet ist, von einem Filterstrom durchflossen zu werden der größer ist als der Sättigungsstromwert, insbesondere, dass die Drosselspule dazu eingerichtet ist, dauerhaft von dem Filternennstrom durchflossen zu werden.

Ganz generell kann eine Drosselspule bzw. jede Drosselspule mit einem Strom durchflossen werden, der größer ist als der Sättigungsstromwert. Dabei ist es unüblich einen Strom durch eine Drosselspule fließen zu lassen, der größer ist als der Sättigungsstromwert. Würde eine nicht speziell dafür dimensionierte Drosselspule mit einem Strom durchflossen werden, der größer ist als der Sättigungsstrom, kann dies zu einer starken Erhitzung führen. In einem ungünstigen Fall kann dies zu einer thermischen Zerstörung der Drosselspule führen. Im Gegensatz dazu ist die vorgeschlagene Drosselspule so ausgelegt, dass diese dauerhaft mit einem Strom durchflossen werden kann, der größer ist als der Sättigungsstromwert. Die Drosselspule wird beispielsweise durch konstruktive Maßnahmen wie eine vergrößerte Wicklungsstärke oder zusätzlichen Kühlstrecken so ausgebildet, dass ein Dauerbetrieb im Sättigungsbereich erreicht wird. Zudem werden die Ummagnetisierungsverluste im Kern durch eine Auswahl geeigneter Trafobleche in Abstimmung mit einem beaufschlagten Frequenzspektrum gering gehalten, so dass es nicht zu einer übermäßigen Erwärmung im Betrieb kommt. Dabei sind Drosselspulen, die nicht explizit wie zuvor beschrieben dafür ausgelegt sind dauerhaft in Sättigung betrieben zu werden, in der Regel nicht dazu geeignet, in einer Filtereinrichtung in der Windenergieanlage bei den genannten Filternennströmen verwendet zu werden.

In einer weiteren Ausführungsform wird vorgeschlagen, dass der Sättigungsstrom der Drosselspule maximal 50%, vorzugsweise maximal 25%, weiter bevorzugt maximal 10%; und insbesondere maximal 5% des Filternennstroms beträgt.

Der Sättigungsstrom der Drosselspule ist in diesem Falle somit ein prozentualer Wert der auf 100 % des Filternennstroms bezogen ist, der bei der Nennleistung des Generators erzeugt wird. Die Drosselspule wird also mit einem signifikant niedrigen Sättigungsstromwert ausgelegt. Besonders bei einem Sättigungsstromwert unter maximal 5% des Filternennstroms, aber selbst bei einem Sättigungsstromwert von unter maximal 10% führt diese Auslegung dazu, dass die Anlage überwiegend im Sättigungsbetrieb arbeitet und nur in besonderen Situationen als ungesättigte Drosselspule betrieben wird. Durch diese Wahl dieser Sättigungsschwelle können auch einfache Art und Weise gezielt zwei Betriebssituationen adressiert werden, nämlich beispielsweise der untere und obere Leistungsbereich des Generators. Vorzugsweise liegt der Sättigungsstromwert unter einem vorbestimmten Filternennstrom der Filtereinrichtung in einem Bereich von 5% bis 50% des Filternennstroms der Nennleistung des Generators erzeugt wird. Vorzugsweise wird vorgeschlagen, dass die Filtereinrichtung der Windenergieanlage ohne jeweils zu der wenigstens einen Drosselspule parallel geschaltete ohmsche Widerstände, insbesondere Dämpfungswiderstände, aufgebaut ist, insbesondere, dass die Filtereinrichtung keine Dämpfungswiderstände aufweist.

Vorteilhaft an der Verwendung einer Drosselspule mit dem zuvor beschriebenen besonderen Verhalten in den beiden Leistungsbereichen ist, dass im Vergleich zu bereits bekannten Filtereinrichtungen auf einen Dämpfungswiderstand verzichtet werden kann. Dieser Dämpfungswiderstand ist bei traditionellen Filtereinrichtungen zur Reduzierung von ungewollt hohen Filterströmen die im Resonanzpunkt auftreten können parallel zu der Drosselspule verschaltet. Diese Dämpfungswiderstände erhitzen sich dabei im Betrieb, so dass ggf. aktive Kühlmittel wie Lüfter zum Kühlen der Widerstände benötigt werden. Es wurde erkannt, dass bei der Verwendung der vorgeschlagenen Drosselspule mit einem ohmschen Verhalten im oberen Leistungsbereich, auf diese Dämpfungswiderstände verzichtet werden kann. Somit kann im Vergleich zu traditionellen Filtereinrichtungen komplett auf den Dämpfungswiderstand sowie die Kühlmittelvorrichtungen für den Widerstand verzichtet werden. Dies führt zu einer Kostenreduktion sowie einer Platzersparnis im konstruktiven Aufbau der Filtereinrichtung.

Gemäß einer weiteren Ausführungsform wird vorgeschlagen, dass der Generator ein oder mehrere dreiphasige Statorsysteme aufweist und zu jedem dreiphasigen Statorsystem die Filtereinrichtung als Drosselspule eine dreiphasige Drossel oder drei einphasige Drosseln mit einem Drosselpfad je Phase aufweist und insbesondere an jedem Drosselpfad ein Kondensator angeschlossen ist. So sind drei Kondensatoren für jedes dreiphasige Statorsystem vorgesehen. Bei einem sechsphasigen Statorsystem des Generators würden sich demnach sechs Kondensatoren ergeben. Dabei sind jeweils drei Kondensatoren in einem Dreieck oder einem Stern verschaltet, wobei insbesondere vorgesehen ist, dass die Filtereinrichtung für jedes dreiphasige Statorsystem als elektrische Bauteile nur die dreiphasige Drosselspule bzw. drei einphasige Drosselspuren und die Kondensatoren aufweist. Demnach ist vorgesehen, dass keine parallelen Dämpfungswiderstände für den konstruktiven Aufbau der Filtereinrichtungen verwendet werden.

Dennoch wird durch die Verwendung der vorgeschlagenen Drosselspule mit zwei unterschiedlichen Leistungsbereichen im Vergleich zu einer traditionellen Filtereinrichtung ein ähnliches schwingungsreduzierendes Verhalten im unteren Leistungsbereich erreicht. Die vorgeschlagene Filtereinrichtung weist dabei aber einen simpleren Aufbau, mit weniger Bauelementen sowie positiven Resonanzeigenschaften auf, so dass insbesondere der benötigte Platz, Zusatzkomponenten wie Kühlmittel und Kosten im Vergleich zu traditionellen Filtereinrichtungen reduziert werden.

Vorzugsweise wird vorgeschlagen, dass der Generator mit einem Gleichrichter zum Gleichrichten des mehrphasigen Generatorstroms verbunden ist. Dabei weist der Generatorstrom mehrere Phasenströme jeweils mit positiven und negativen Halbwellen auf. Der Generator erzeugt demnach eine mehrphasige Wechselspannung. Der mehrphasige Generatorstrom wird einem Gleichrichter zugeführt, wobei der Gleichrichter für jeden Phasenstrom jeweils zwei Thyristoren zum Gleichrichten der Wechselspannung aufweist. Die zwei Thyristoren sind ein positiv eingesetzter Thyristor zum Gleichrichten der positiven Halbwellen in eine positive Gleichspannung und ein negativ eingesetzter Thyristor zum Gleichrichten der negativen Halbwellen in eine negative Gleichspannung. Dabei ist jeweils eine Phase zwischen den beiden Thyristoren elektrisch angeschlossen. Dabei wird der positiv eingesetzte Thyristor bei ansteigender Phase zum Einschalten angesteuert, und der negative eingesetzte Thyristor bei abfallender Phase zum Einschalten angesteuert. Die in der Filtereinrichtung eingesetzte Drosselspule bzw. dessen Induktivität ist dabei so dimensioniert, dass sie einen Strom halten kann, um einem ungewollten Löschen des jeweiligen Thyristors durch einen unter einen Haltestrom absinkenden Phasenstrom entgegenzuwirken, besonders in der Nähe eines Nulldurchgangs des Phasenstroms und insbesondere bei kleinen Generatorleistungen.

Es wurde erkannt, dass wenn die Drosselspule in der Nähe eines Nulldurchgangs des Phasenstroms und bei kleinen Generatorleistungen ausreichend groß dimensioniert ist, eine signifikante Verringerung der elektrischen Schwingungen in der Nähe des Nulldurchgangs erreicht werden kann. Besonders in der Nähe eines Nulldurchgangs entstehen ungewünschte elektrische Schwingungen, die durch den Gleichrichter erzeugt werden bzw. durch die im Gleichrichter verwendeten Gleichrichtmittel, wie beispielsweise Thyristoren. Solche Schwingungen entstehen zum Beispiel, wenn die verwendeten Thyristoren unsauber Durchsteuern. Ein unsauberes Durchsteuern tritt dabei verstärkt dann auf, wenn der Generatorstrom in der Nähe des Nulldurchgangs unterhalb des Haltestroms des Thyristors liegt. Ist der Generatorstrom bzw. der betreffende Phasenstrom kleiner als der Haltestrom der Thyristoren tritt der Effekt auf, dass die Thyristoren obwohl sie eingeschaltet werden, sich eigenständig wieder löschen. Somit zünden die Thyristoren mehrfach und schalten sich aber daraufhin wieder eigenständig ab. Dieser Effekt führt zu elektrischen Schwingungen besonders in der Nähe des Nulldurchgangs. Um diesem ungewünschten Effekt entgegenzuwirken wird die Induktivität der Drosselspule so dimensioniert, dass sie einen Strom halten kann, um einem ungewollten Löschen des jeweiligen Thyristors durch einen unter einen Haltestrom absinkenden Phasenstrom entgegenzuwirken.

Ferner wird erfindungsgemäß zudem ein Verfahren zur Auslegung einer Drosselspule zur Verwendung in einer Filtereinrichtung in einer Windenergieanlage gemäß wenigstens einer vorstehend oder nachfolgend beschriebenen Ausführungsform vorgeschlagen.

Dazu umfasst die Windenergieanlage einen mehrphasigen Generator, insbesondere einen Synchrongenerator, zum Erzeugen elektrischer Leistung, wobei der Generator einen mehrphasigen Generatorstrom erzeugt, und wobei der Generator einen Generatorausgang zum Abgeben des mehrphasigen Generatorstroms aufweist. Weiterhin umfasst die Windenergieanlage eine an den Generatorausgang angeschlossene Filtereinrichtung zum Erzeugen eines Filterstroms (I_{F}) zum Beeinflussen des Generatorstroms, insbesondere zum Reduzieren elektrischer Schwingungen des Generatorstroms bzw. zur Kompensation einer Verzerrungsblindleistung, wobei der erzeugte Filterstrom von der erzeugten Leistung des Generators abhängig ist, und wobei der Leistungsgrenzwert unterhalb einer Nennleistung des Generators liegt. Dazu umfasst die Filtereinrichtung wenigstens eine Kapazität zum Beeinflussen des Filterstroms, und wenigstens eine der Kapazität in Serie vorgeschaltete Drosselspule zum Beeinflussen des Filterstroms, wobei die Drosselspule einen Sättigungsstromwert aufweist, der eine Amplitude des Filterstromes bezeichnet, bei der die Drosselspule einen magnetischen Sättigungszustand aufweist. Hierfür wird die Drosselspule so ausgelegt, dass der Sättigungsstromwert unter einem vorbestimmten Filternennstrom der Filtereinrichtung liegt.

Demnach wird die Drosselspule so ausgelegt, dass der Sättigungsstromwert unter einem vorbestimmten Filternennstrom der Filtereinrichtung liegt. Ist bspw. ein induktives Verhalten unter 10 % des Filternennstroms gewünscht, besteht der Auslegungsschritt darin, die Spule so konstruktiv aufzubauen, dass der Sättigungsstromwert der Drosselspule dem gewünschten prozentualen Filternennstrom entspricht. Als Beispiel könnte ein Generator bei 100 % Nennleistung einen Filternennstrom von 300A erzeugen. Nun ist die Spule so auszulegen, dass der Sättigungsstromwert bei 30A (10% des Filternennstroms) liegt und somit ein im Wesentlichen induktives Verhalten von 0% bis ausschließlich 10 % des Filternennstroms vorliegt. Oberhalb des Sättigungswertes liegt in diesem Beispiel bei 10 % bis 100 % des Filternennstroms dann ein im Wesentlichen ohmsches Verhalten vor. Die Windungsanzahl und Windungsstärke sowie Größe und Material des Kerns werden entsprechend gewählt.

In dem genannten veranschaulichenden Beispiel weist die Drosselspule somit von 0 bis 30A ein im Wesentlichen induktiven Verhalten auf und ab 30A ein im Wesentlichen ohmsches Verhalten auf. Wie zuvor beschrieben, ist der Übergang vom unteren Leistungsbereich in den oberen Leistungsbereich nicht sprunghaft, sondern fließend. Dem Fachmann ist dabei bewusst, dass auch nach Überschreiten des Filterstroms über den Sättigungsstromwert die Induktivität erst wenig abgefallen ist und ein Übergangsbereich, in dem die Induktivität absinkt, physikalisch begründet vorliegt.

Vorzugsweise wird vorgeschlagen, dass die Drosselspule so ausgelegt wird, dass diese bei einem Filterstrom unterhalb des Sättigungsstromwertes ein im Wesentlichen induktives Verhalten aufweist und bei einem Filterstrom oberhalb des Sättigungsstromwertes ein im Wesentlichen ohmsches Verhalten aufweist. Dies kann dadurch erreicht werden, dass der Sättigungsstromwert der Spule so gewählt wird, dass er einem prozentualen vorgegebenen Wert entspricht der unterhalb des Filternennstroms liegt.

Gemäß einer weiteren Ausführungsform wird vorgeschlagen, dass der Sättigungsstrom der Drosselspule maximal 50%, vorzugsweise maximal 25%, weiter bevorzugt maximal 10% und insbesondere maximal 5% des Filternennstroms beträgt.

Je nach Generatortyp kann die Drosselspule somit daran angepasst werden, ein bestmögliches Reduzieren von Schwingungen bei einem Generatorstrom unterhalb des Sättigungsstromwerts zu erzielen. Vorzugsweise liegt der Sättigungsstromwert in einem Bereich von 5% bis 50% des Filternennstroms der Filtereinrichtung der sich bei Nennleistung des Generators einstellt.

In einer weiteren Ausführungsform wird vorgeschlagen, dass die Drosselspule so ausgelegt wird, dass diese dazu eingerichtet ist von einem Filterstrom durchflossen zu werden der größer ist als der Sättigungsstromwert, insbesondere, dass die Drosselspule dazu eingerichtet ist, dauerhaft von dem Filternennstrom durchflossen zu werden. Es wird also vorgeschlagen, dass die Drosselspule durch ihren konstruktiven Aufbau dauerhaft mit einem Filterstrom durchflossen werden kann, der größer ist als der Sättigungsstromwert. Bei konventionellen Drosselspulen ist dies in der Regel nicht möglich. Bei üblichen Drosselspulen wird nämlich vermieden, dass der Sättigungsbereich überhaupt erreicht wird. Eine dem Fachmann bekannte Daumenregel ist, dass der Sättigungsbereich wenigstens doppelt so groß ist wie der maximale Strom, der geplant durch die Drossel fließt. In der vorgeschlagenen Lösung ist es jedoch gewünscht, dass der Sättigungswert deutlich unterhalb des maximalen Stroms liegt, der durch die Drosselspule fließen kann. Der maximale geplante Strom der durch die Drosselspule fließt ist dabei der Filternennstrom.

Vorzugsweise wird vorgeschlagen, dass das Auslegen der Drosselspule zusätzlich umfasst, dass Eisenverluste der Drosselspule so gewählt werden, dass die Filtereinrichtung ohne jeweils zu der Drosselspule parallel geschaltete ohmsche Widerstände, insbesondere Dämpfungswiderstände, aufgebaut werden kann, insbesondere so, dass die Filtereinrichtung, für die die Drosselspule vorgesehen ist, bei der vorgesehenen Verwendung in der Windenergieanlage ohne Dämpfungswiderstände auskommt.

Durch das Sättigungsverhalten können die Dämpfungswiderstände im konstruktiven Aufbau der Filtereinrichtungen weggelassen werden. Somit können Kosten im konstruktiven Aufbau gespart werden und die Filtereinrichtung insgesamt kompakter aufgebaut werden.

Ferner wird erfindungsgemäß ein Verfahren zum Umrüsten einer Windenergieanlage, durch Umrüsten einer Filtereinrichtung vorgeschlagen.

Dabei umfasst die Windenergieanlage einen mehrphasigen Generator, insbesondere einen Synchrongenerator, zum Erzeugen elektrischer Leistung, wobei der Generator einen mehrphasigen Generatorstrom erzeugt, und wobei der Generator einen Generatorausgang zum Abgeben des mehrphasigen Generatorstroms aufweist, wobei der Generator in einem unteren und einem oberen Leistungsbereich betreibbar ist, wobei der Generator im unteren Leistungsbereich betrieben wird, wenn die erzeugte Leistung des Generators einen vorbestimmten Leistungsgrenzwert nicht überschreitet, und der Generator im oberen Leistungsbereich betrieben wird, wenn die erzeugte Leistung des Generators dem vorbestimmten Leistungsgrenzwert entspricht oder diesen überschreitet. Die Windenergieanlage umfasst auch eine an den Generatorausgang angeschlossene Filtereinrichtung zum Erzeugen eines Filterstroms zum Beeinflussen des Generatorstroms, insbesondere zum Reduzieren elektrischer Schwingungen des Generatorstroms, wobei der erzeugte Filterstrom von der erzeugten Leistung des Generators abhängig ist.

Zu einer so aufgebauten Windenergieanlage wird nun vorgeschlagen, eine bisherige Filtereinrichtung oder einen Teil davon mit einer veränderten Filtereinrichtung oder eines Teils davon zu ersetzen, so dass die Windenergieanlage nach dem Umrüsten eine veränderte Filtereinrichtung aufweist. Dabei umfasst die veränderte Filtereinrichtung wenigstens eine Kapazität zum Beeinflussen des Filterstroms, und wenigstens eine der Kapazität in Serie vorgeschaltete Drosselspule zum Beeinflussen des Filterstroms, wobei die Drosselspule einen Sättigungsstromwert aufweist, der eine Amplitude des Filterstromes bezeichnet, bei der die Drosselspule einen magnetischen Sättigungszustand erreicht, und wobei der Sättigungsstromwert unter einem vorbestimmten Filternennstrom der Filtereinrichtung liegt.

Von der bisherigen Filtereinrichtung wird somit zumindest eine Filterdrossel bzw. alle Filterdrosseln ersetzt, nämlich besonders jeweils durch eine mit einem geringeren Sättigungsstrom. Außerdem wird, zumindest als optionaler Schritt, das Entfernen etwaiger Dämpfungswiderstände durchgeführt, besonders so, dass danach keine Dämpfungswiderstände mehr vorhanden sind.

Vorzugsweise wird vorgeschlagen, dass vorhandene Drosselspulen durch einen nach einem der vorstehenden Ausführungsformen des Verfahrens zur Auslegung einer Drosselspule zur Verwendung in einer Filtereinrichtung in einer Windenergieanlage ausgelegte Drosselspulen ersetzt wird und insbesondere, in der bisherigen Filtereinrichtung vorhandene Dämpfungswiderstände entfernt werden.

Demnach wird vorgeschlagen, dass nicht nur die bisherige Filtereinrichtung ersetzt wird, sondern auch, dass dabei die nicht benötigten Dämpfungswiderstände der bisherigen Filtereinrichtungen und ebenfalls nicht mehr benötigten Kühlungsvorrichtungen, wie z.B. Lüfter mitsamt Ansteuerung oder Ventilationsöffnungen entfernt werden.

Demnach wird ermöglicht, bereits bestehende Windenergieanlagen mit der veränderten Filtereinrichtung nachzurüsten bzw. eine bisherig verwendete Filtereinrichtung umzubauen. Durch die Verwendung weniger Komponenten in der veränderten Filtereinrichtung steigt somit die Ausfallsicherheit der Windenergieanlage.

Die vorliegende Erfindung wird nun nachfolgend exemplarisch anhand von Ausführungsbeispielen unter Bezugnahme auf die begleitenden Figuren näher erläutert.
- Figur 1: zeigt eine Windenergieanlage in einer perspektivischen Darstellung.
- Figur 2: zeigt eine veranschaulichende Darstellung eines Generator- und Gleichrichtersystems.
- Figur 3: zeigt einen schematischen Verlauf eines Induktionswerts einer Drosselspule in Abhängigkeit des durch die Drosselspule fließenden Stroms.
- Figur 4: zeigt einen Vergleich eines Schaltschranks mit einer konventionellen Filteranlage sowie eines Schaltranks mit einer erfindungsgemäßen Filtereinrichtung.

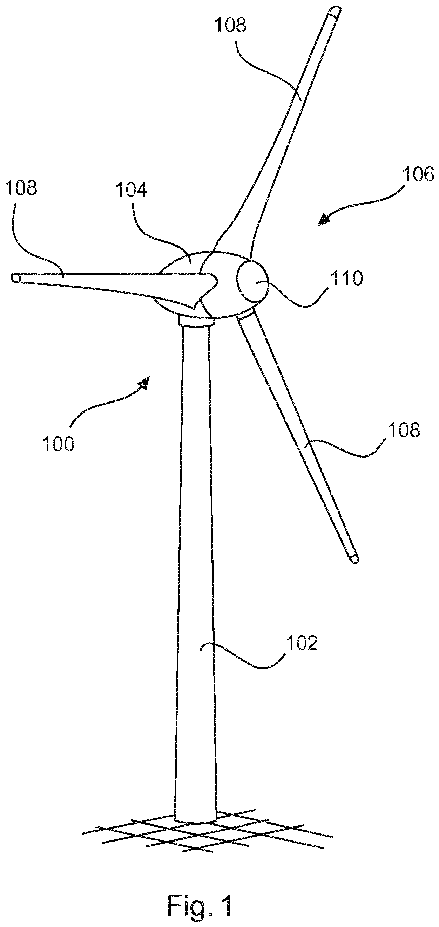

Figur 1 zeigt eine Windenergieanlage 100 mit einem Turm 102 und einer Gondel 104. An der Gondel 104 ist ein Rotor 106 mit drei Rotorblättern 108 und einem Spinner 110 angeordnet. Der Rotor 106 wird im Betrieb durch den Wind in eine Drehbewegung versetzt und treibt dadurch einen Generator in der Gondel 104 an.

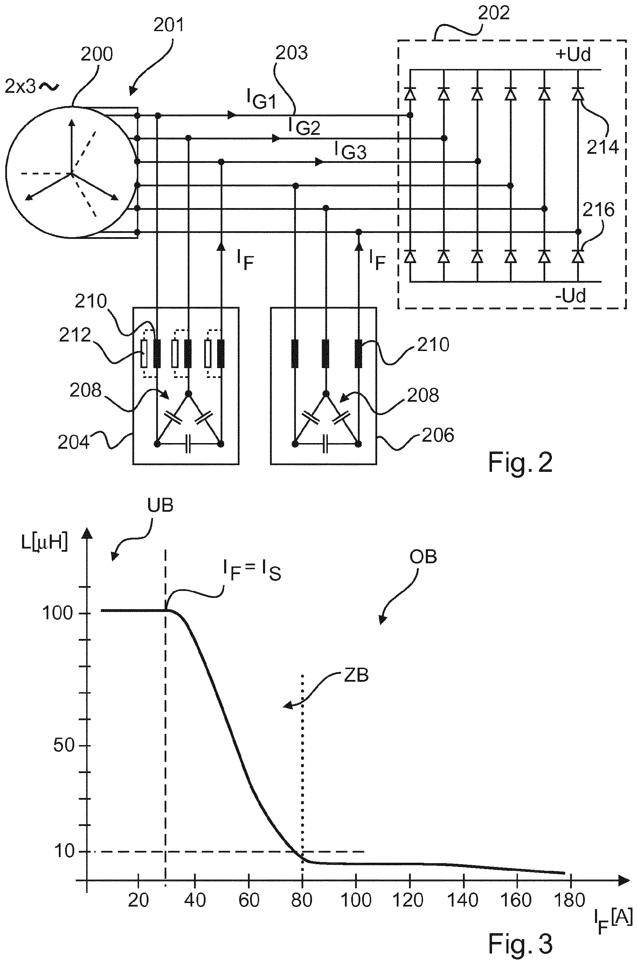

Figur 2 zeigt ein Generator- und Gleichrichtersystem, wie einer Windenergieanlage mit einem Synchrongenerator. Dabei erzeugt der Generator 200 einen sechsphasigen Generatorstrom, von denen nachfolgend besonders die drei Phasen I_{G1}, I_{G2} und I_{G3} betrachtet werden. Der Generator ist sechsphasig ausgeführt, so dass zwei dreiphasige Statorsysteme vorliegen. Der Generator 200 ist dabei über sechs im Wesentlichen parallel verlaufende Phasenleitungen 203 mit einer Gleichrichtereinheit 202 verbunden. Damit die Phasenleitungen 203 mit dem Generator 200 elektrisch gekoppelt werden können, sind Anschlussmittel am Generator 200 an einem Generatorausgang 201 vorgesehen. Die Gleichrichtereinheit ist dabei als passiver Gleichrichter ausgebildet. Die Schaltmittel können als Thyristoren ausgeführt sein. Für jeden Phasenstrom werden zwei Thyristoren zum Gleichrichten der Wechselspannung verwendet, nämlich ein positiv eingesetzter Thyristor 214 zum Gleichrichten der positiven Halbwellen in eine positive Gleichspannung und ein negativ eingesetzter Thyristor 216 zum Gleichrichten der negativen Halbwellen in eine negative Gleichspannung. Der Generator weist somit zwei dreiphasige Statorsysteme auf. An jeweils einen der beiden dreiphasigen Statorsysteme ist dabei eine Filtereinrichtung 204, 206 angeschlossen.

Die in der Figur 2 gezeigten Filtereinrichtungen 204 und 206 weisen dabei jeweils drei Drosselspulen 210 sowie jeweils ein Kapazitätsnetzwerk 208 auf. Die Drosselspule wird synonym auch als Induktivität bezeichnet. Demnach ist die Filtereinrichtung aus passiven Bauelementen aufgebaut. Beide Filtereinrichtungen 204 und 206 erzeugen bzw. verursachen dabei einen Filterstrom I_{F}, der auch auf das jeweilige Statorsystem einwirkt. Ein Kapazitätsnetzwerk 208 ist dabei als Dreieckschaltung ausgeführt. Dem Kapazitätsnetzwerk 208 vorgeschaltet, ist eine Drosselspule 210. Die Drosselspule 210, die als eine dreiphasige Drossel oder als drei einphasige Drosseln ausgebildet sein kann, wird dabei von einem Filterstrom I_{F} durchströmt. Die Filtereinrichtungen 204 und 206 sind somit über die Knotenpunkte mit dem Generatorausgang elektrisch verbunden. So kann die angeschlossene und mit dem Generatorausgang verbundene Filtereinrichtung zum Erzeugen eines Filterstroms zum Reduzieren der elektrischen Schwingungen des Generatorstroms genutzt werden. Durch die vom Generator erzeugte Wechselspannung wird dann ein von der erzeugten Leistung des Generators abhängiger Filterstrom I_{F} durch das Kapazitätsnetzwerk 208 beeinflusst.

Die Filtereinrichtung 204 weist im Gegensatz zu der Filtereinrichtung 206 angedeutete Dämpfungswiderstände 212 auf, die nicht tatsächlich verschaltet sind und nur durch die gepunktete Verbindung veranschaulicht werden, um den Vergleich zu traditionellen Filtereinrichtungen aufzuzeigen. Diese Dämpfungswiderstände werden in konventionellen Filtereinrichtungen zur Dämpfung von auftretenden LC-Schwingkreisen verwendet. Wird eine Drosselspule gemäß den zuvor beschriebenen Ausführungsformen eingesetzt, kann auf diese Dämpfungswiderstände, die im Wesentlichen parallel zur Drosselspule 210 angeordnet sind, verzichtet werden.

Figur 3 zeigt ein Diagramm, in dem die Abhängigkeit der Induktivität der Drosselspule vom Filterstrom I_{F} gezeigt wird. Zur Veranschaulichung ist eine Aufteilung in einen oberen (OB) und einen unteren Leistungsbereich (UB) vorgenommen worden. Dazu ist auf der Ordinate die Induktivität der Drosselspule in µH abgetragen sowie auf der Abszisse der Filterstrom I_{F} in Ampere abgetragen. Hierbei weist der gezeigte Verlauf der Induktivität in Abhängigkeit des Stroms, einen in grober Näherung konstanten Verlauf im unteren Leistungsbereich UB auf.

Wird der Sättigungsstromwert erreicht, der bei einem vorbestimmten Leistungsgrenzwert auftreten kann, was im vorliegenden Fall bei 30 Ampere ist, fällt die Induktivität mit steigendem Strom ab. Entspricht der Filterstrom dem Sättigungsstromwert I_{S} oder ist er größer als der Sättigungsstromwert, liegt der obere Leistungsbereich OB vor. Im gezeigten Beispiel der Figur 3, fällt die Induktivität von 100 µH auf unter 10 µH in einem Zwischenbereich ZB von 30 bis 80 Ampere ab. Unter der Annahme, dass der Generator einen maximalen Filterstrom I_{F} bzw. einen Filternennstrom von 300 Ampere bei einer Nennleistung von 100 % erzeugt, ist in dem in der Figur 3 gezeigten Beispiel die Drosselspule so ausgelegt, dass der untere Leistungsbereich von 0 bis 10 %, nämlich 30 Ampere von 300 vorliegt. Der obere Leistungsbereich entspricht dann einschließlich 30 Ampere bis 300 Ampere. Dabei kann der Zwischenbereich zwischen 30 und 80 Ampere dem oberen Leistungsbereich zugeordnet werden, um den Sachverhalt bzw. die Unterscheidung zwischen dem unteren und dem oberen Leistungsbereich zu vereinfachen. Demnach beträgt der Sättigungsstromwert der Drosselspule im gezeigten Beispiel der Figur 3 einem vorbestimmten Filternennstrom von 30A. Der Sättigungsstromwert liegt somit unterhalb des Filternennstroms von 300A, bzw. beträgt 10% des Filternennstroms.

Der Sättigungsstromwert ist somit als ein Definitionsgrenzwert zu verstehen, der als typischer Wert in jedem Datenblatt einer Spule angegeben ist.

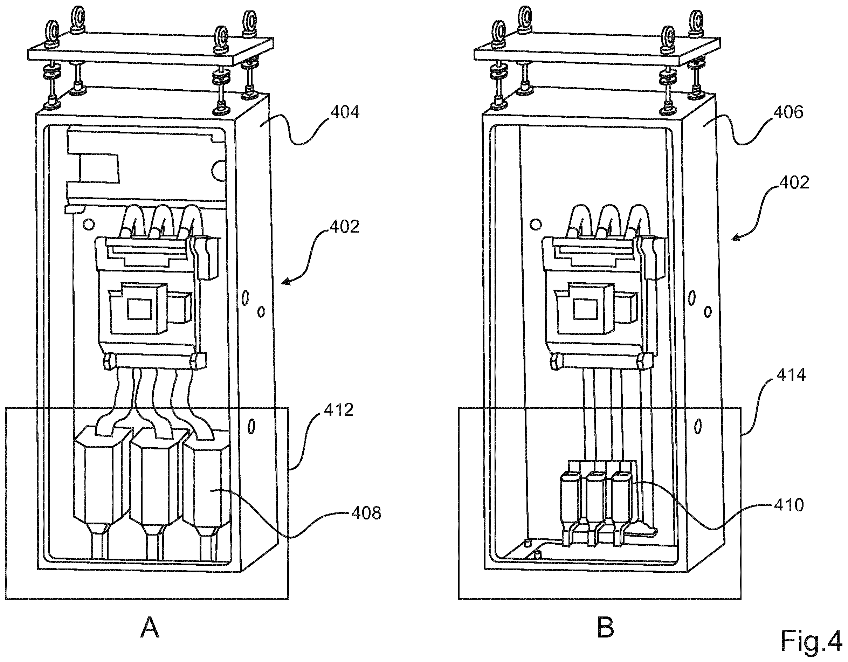

Die Figuren 4A und 4B zeigen jeweils eine Filtereinrichtung (400, 402) in einem Filterschrank (404, 406) in einer Windenergieanlage. Dabei zeigt die Figur 4A einen konventionellen Filterschrank 404 ohne eine erfindungsgemäße Drosselspule und die Figur 4B einen Filterschrank 406 mit einer erfindungsgemäßen Drosselspule. Beide Filtereinrichtungen sind für einen gleichen Einsatzort vorgesehen, insbesondere für ein wie in Fig. 2 gezeigtes Generator- und Gleichrichtersystem gleicher Leistung und Bauart. Figur 4A könnte eine Filtereinrichtung vor einer Umrüstung und Figur 4B nach der Umrüstung zeigen. Vergleicht man die mit den Rechtecken 412, 414 hervorgehobenen Filterdrosseln 408, 410 im unteren Bereich der beiden Filterschränke fällt auf, dass die Filterdrossel 410 in der Figur 4B wesentlich kleiner und kompakter aufgebaut werden kann, als die in Figur 4A. Durch die Verwendung der vorgeschlagenen Drosselspule können somit parallel zur Drossel geschaltete Dämpfungswiderstände entfallen. Zudem kann die Filtereinrichtung mit weniger Bauvolumen, weniger Gewicht und Verdrahtungsaufwand implementiert werden und Kühlstrecken aufgrund der geringeren Verlustleistung ebenso verkleinert werden.

Abschließend werden stichpunktartig Vorteile genannt, die gemäß wenigstens einer der vorstehenden Ausführungsformen erreicht werden können, zumindest angestrebt sind. Die Verwendung der erfindungsgemäßen Drosselspule in der Filtereinrichtung kann die Vorteile aufweisen, dass
- die Drosselspule nur in einem gewünschten unteren Leistungsbereich induktiv wirksam ist;
- die Drosselspule einen Resonanzpunkt durch Sättigung in unkritische Frequenzbereiche verschiebt;
- die Drosselspule die Filterströme bei gleichem Oberschwingungsverhalten reduziert.
- ein Erregerstrom des Generators reduziert wird;
- die Drosselspule Stromrippel im Zwischenkreis reduziert;
- die Filtereinrichtung günstiger, kleiner und leichter aufgebaut werden kann;
- durch die Verwendung der Drosselspule die Dämpfungswiderstände wegfallen können. Durch den Wegfall der Dämpfungswiderstände können somit auch Komponenten wie aktive Lüfter, Temperaturschalter und Surge-Absorber entfallen;
- das Gehäuse der Filtereinrichtung vereinfacht werden kann;
- der Verdrahtungsaufwand der Filtereinrichtung geringer ist;
- weniger Verlustleistung in der Filtereinrichtung erzeugt wird;
- die Wirkung des kapazitiven Filters erhöht wird;
- die Filtereinrichtung bzw. die Filterschränke robuster mit einer höheren-Schutzklasse (IP54) aufgebaut werden können.

## Patentansprüche

1. Windenergieanlage (100) zum Erzeugen einer elektrischen Leistung zum Einspeisen in ein elektrisches Versorgungsnetz, umfassend:
- einen mehrphasigen Generator (200), insbesondere einen Synchrongenerator, zum Erzeugen elektrischer Leistung, wobei der Generator einen mehrphasigen Generatorstrom (I_{G1}, I_{G2}, I_{G3}) erzeugt, und wobei der Generator einen Generatorausgang (201) zum Abgeben des mehrphasigen Generatorstroms aufweist,
- eine an den Generatorausgang angeschlossene Filtereinrichtung (204, 206) zum Erzeugen eines Filterstroms (I_{F}) zum Beeinflussen des Generatorstroms zum Reduzieren elektrischer Schwingungen des Generatorstroms, wobei
- der erzeugte Filterstrom von der erzeugten Leistung des Generators abhängig ist, und
- die Filtereinrichtung umfasst
- wenigstens eine Kapazität (208) zum Beeinflussen des Filterstroms, und
- wenigstens eine der Kapazität in Serie vorgeschaltete Drosselspule (210) zum Beeinflussen des Filterstroms, wobei
- die Drosselspule einen Sättigungsstromwert aufweist, der eine Amplitude des Filterstromes bezeichnet, bei der die Drosselspule einen magnetischen Sättigungszustand aufweist, und wobei der Sättigungsstromwert unter einem vorbestimmten Filternennstrom der Filtereinrichtung liegt, **dadurch gekennzeichnet, dass** der Sättigungsstrom der Drosselspule (210) maximal 50% des Filternennstroms beträgt.

2. Windenergieanlage nach Anspruch 1,
**dadurch gekennzeichnet, dass**
die Drosselspule (210)
- bei einem Filterstrom unterhalb des Sättigungsstromwertes ein induktives Verhalten und
- bei einem Filterstrom oberhalb des Sättigungsstromwertes ein ohmsches Verhalten aufweist.

3. Windenergieanlage nach Anspruch 1 oder 2,
**dadurch gekennzeichnet, dass**
- die Drosselspule (210) dazu eingerichtet ist von einem Filterstrom durchflossen zu werden der größer ist als der Sättigungsstromwert, wobei die Drosselspule dazu eingerichtet ist, dauerhaft von dem Filternennstrom durchflossen zu werden.

4. Windenergieanlage nach Anspruch 1,
**dadurch gekennzeichnet, dass**
der Sättigungsstrom der Drosselspule (210)
- maximal 25%;
- maximal 10%; oder
- maximal 5%
des Filternennstroms beträgt.

5. Windenergieanlage nach einem der vorstehenden Ansprüche,
**dadurch gekennzeichnet, dass**
- die Filtereinrichtung (204, 206) ohne jeweils zu der wenigstens einen Drosselspule parallelgeschaltete ohmsche Widerstände (212), nämlich Dämpfungswiderstande, aufgebaut ist, insbesondere, dass
- die Filtereinrichtung keine Dämpfungswiderstände aufweist.

6. Windenergieanlage nach einem der vorstehenden Ansprüche,
**dadurch gekennzeichnet, dass**
- der Generator (200) ein oder mehrere dreiphasige Statorsysteme aufweist und
- zu jedem dreiphasigen Statorsystem die Filtereinrichtung (204, 206) als Drosselspule (210) eine dreiphasige Drossel oder drei einphasige Drosseln mit einem Drosselpfad je Phase aufweist und
- an jeden Drosselpfad ein Kondensator angeschlossen ist,
- so dass drei Kondensatoren für jedes dreiphasige Statorsystem vorgesehen sind, und wobei
- diese drei Kondensatoren (208) in einem Dreieck oder einem Stern verschaltet sind, wobei insbesondere vorgesehen ist, dass
- die Filtereinrichtung (204, 206) für jedes dreiphasige Statorsystem als elektrische Bauteile nur die ein- oder dreiphasige Drossel und die drei Kondensatoren aufweist.

7. Windenergieanlage nach einem der vorstehenden Ansprüche,
**dadurch gekennzeichnet, dass**
der Generator (200) mit einem Gleichrichter (202) verbunden ist, zum Gleichrichten des mehrphasigen Generatorstroms,
wobei der Generatorstrom mehrere Phasenströme jeweils mit positiven und negativen Halbwellen aufweist,
- der mehrphasige Generatorstrom dem Gleichrichter zugeführt wird, wobei
- der Gleichrichter für jeden Phasenstrom
- einen positiv eingesetzten Thyristor (214) zum Gleichrichten der positiven Halbwellen in eine positive Gleichspannung und
- einen negativ eingesetzten Thyristor (216) zum Gleichrichten der negativen Halbwellen in eine negative Gleichspannung aufweist, wobei
- der positiv eingesetzte Thyristor bei ansteigender Phase zum Einschalten angesteuert wird, und
- der negative eingesetzte Thyristor bei abfallender Phase zum Einschalten angesteuert wird,
- die Induktivitäten der Drosselspulen (210) so dimensioniert sind, dass sie einen Strom halten kann, um einem ungewollten Löschen des jeweiligen Thyristors durch einen unter einen Haltestrom absinkenden Phasenstrom entgegenzuwirken, besonders in der Nähe eines Nulldurchgangs des Phasenstroms und bei kleinen Generatorleistungen.

8. Verfahren zur Auslegung einer Drosselspule (210) zur Verwendung in einer Filtereinrichtung (204, 206) in einer Windenergieanlage (100) und die Windenergieanlage umfasst,
- einen mehrphasigen Generator (200), insbesondere einen Synchrongenerator, zum Erzeugen elektrischer Leistung, wobei der Generator einen mehrphasigen Generatorstrom (I_{G1}, I_{G2}, I_{G3}) erzeugt, und wobei der Generator einen Generatorausgang (201) zum Abgeben des mehrphasigen Generatorstroms aufweist,
- eine an den Generatorausgang angeschlossene Filtereinrichtung (204, 206) zum Erzeugen eines Filterstroms (I_{F}) zum Beeinflussen des Generatorstroms, zum Reduzieren elektrischer Schwingungen des Generatorstroms, wobei
- der erzeugte Filterstrom von der erzeugten Leistung des Generators abhängig ist, und
- die Filtereinrichtung umfasst
- wenigstens eine Kapazität (208) zum Beeinflussen des Filterstroms, und
- wenigstens eine der Kapazität in Serie vorgeschaltete Drosselspule (210) zum Beeinflussen des Filterstroms, wobei
- die Drosselspule einen Sättigungsstromwert aufweist, der eine Amplitude des Filterstromes bezeichnet, bei der die Drosselspule einen magnetischen Sättigungszustand aufweist, und wobei die Drosselspule so ausgelegt wird, dass der Sättigungsstromwert unter einem vorbestimmten Filternennstrom der Filtereinrichtung liegt, **dadurch gekennzeichnet, dass** der Sättigungsstrom der Drosselspule (210) maximal 50% des Filternennstroms beträgt.

9. Verfahren nach Anspruch 8,
**dadurch gekennzeichnet, dass**
die Drosselspule (210) so ausgelegt wird, dass diese
- bei einem Filterstrom unterhalb des Sättigungsstromwertes ein induktives Verhalten aufweist und
- bei einem Filterstrom oberhalb des Sättigungsstromwertes ein ohmsches Verhalten aufweist.

10. Verfahren nach Anspruch 8 oder 9,
**dadurch gekennzeichnet, dass**
die Drosselspule (210) so ausgelegt wird, dass diese
- dazu eingerichtet ist von einem Filterstrom durchflossen zu werden der größer ist als der Sättigungsstromwert, wobei die Drosselspule dazu eingerichtet ist, dauerhaft von dem Filternennstrom durchflossen zu werden.

11. Verfahren nach Anspruch 8 bis 10,
**dadurch gekennzeichnet, dass**
der Sättigungsstrom der Drosselspule (210)
- maximal 25%;
- maximal 10%; oder
- maximal 5%
des Filternennstroms beträgt.

12. Verfahren nach einem der Ansprüche 8 bis 11,
**dadurch gekennzeichnet, dass**
- das Auslegen der Drosselspule (210) zusätzlich umfasst, dass
- Eisenverluste der Drosselspule so gewählt werden, dass die Filtereinrichtung ohne jeweils zu der Drosselspule parallelgeschaltete ohmsche Widerstände, nämlich Dämpfungswiderstande, aufgebaut werden kann, insbesondere so, dass
- die Filtereinrichtung keine Dämpfungswiderstände aufweist.

13. Verfahren zum Umrüsten einer Windenergieanlage (100), durch Umrüsten einer Filtereinrichtung, und die Windenergieanlage umfasst
- einen mehrphasigen Generator (200), insbesondere einen Synchrongenerator, zum Erzeugen elektrischer Leistung, wobei der Generator einen mehrphasigen Generatorstrom (I_{G1}, I_{G2}, I_{G3}) erzeugt, und wobei der Generator einen Generatorausgang zum Abgeben des mehrphasigen Generatorstroms aufweist,
- eine an den Generatorausgang angeschlossene Filtereinrichtung zum Erzeugen eines Filterstroms (I_{F}) zum Beeinflussen des Generatorstroms zum Reduzieren elektrischer Schwingungen des Generatorstroms, wobei
- der erzeugte Filterstrom von der erzeugten Leistung des Generators abhängig ist,
und das Verfahren umfasst:
- Ersetzten einer bisherigen Filtereinrichtung oder eines Teils davon mit einer veränderten Filtereinrichtung oder eines Teils davon, so dass die Windenergieanlage nach dem Umrüsten eine veränderte Filtereinrichtung aufweist, und
- die veränderte Filtereinrichtung (204, 206) umfasst
- wenigstens eine Kapazität (208) zum Beeinflussen des Filterstroms, und
- wenigstens eine der Kapazität in Serie vorgeschaltete Drosselspule (210) zum Beeinflussen des Filterstroms, wobei
- die Drosselspule einen Sättigungsstromwert aufweist, der eine Amplitude des Filterstromes bezeichnet, bei der die Drosselspule einen magnetischen Sättigungszustand aufweist, und wobei
- der Sättigungsstromwert unter einem vorbestimmten Filternennstrom der Filtereinrichtung liegt,
**gekennzeichnet dadurch, dass** der Sättigungsstrom der Drosselspule (210) maximal 50% des Filternennstroms beträgt.

14. Verfahren zum Umrüsten einer Windenergieanlage (100) nach Anspruch 13,
**dadurch gekennzeichnet, dass**
- von der bisherigen Filtereinrichtung zumindest eine Filterdrossel bzw. alle Filterdrosseln jeweils durch eine mit einem geringeren Sättigungsstrom ersetzt wird bzw. werden und dass außerdem oder optional
- Dämpfungswiderstände aus der bisherigen Filtereinrichtung entfernt werden, besonders so, dass danach keine Dämpfungswiderstände mehr in der umgerüsteten Filtereinrichtung vorhanden sind.

15. Verfahren zum Umrüsten einer Windenergieanlage (100) nach Anspruch 13 oder 14,
**dadurch gekennzeichnet, dass**
- vorhandene Drosselspulen jeweils durch eine nach einem der Ansprüche 7 bis 11 ausgelegte Drosselspule ersetzt werden und dass
- aus der bisherigen Filtereinrichtung vorhandene Dämpfungswiderstände entfernt werden.

## Claims

1. A wind turbine (100) for generating an electric power for feeding into an electric supply grid including:
- a multiphase generator (200), in particular a synchronous generator, for generating electric power, wherein the generator generates a multiphase generator current (I_{G1}, I_{G2}, I_{G3}) and wherein the generator has a generator output (201) for output of the multiphase generator current,
- a filter device (204, 206) connected to the generator output for generating a filter current (I_{F}) for influencing the generator current for reducing electric oscillations of the generator current, wherein
- the generated filter current is dependent on the generated power of the generator, and
- the filter device includes
- at least one capacitor (208) for influencing the filter current, and
- at least one choke coil (210) connected in series upstream of the capacitor for influencing the filter current, wherein
- the choke coil has a saturation current value which indicates an amplitude of the filter current, at which the choke coil has a magnetic saturation state, and wherein
- the saturation current value is below a predetermined filter nominal current of the filter device,
**characterized in that**
the saturation current of the choke coil (210) is at a maximum 50% of the filter nominal current.

2. A wind turbine according to claim 1
**characterised in that**
the choke coil (210) has
- with a filter current below the saturation current value an inductive behaviour, and
- with a filter current above the saturation current value an ohmic behaviour.

3. A wind turbine according to claim 1 or claim 2
**characterised in that**
- the choke coil (210) is adapted to have flowing therethrough a filter current greater than the saturation current value, wherein the choke coil is adapted to have the filter nominal current permanently flowing therethrough.

4. A wind turbine according to claim 1
**characterised in that**
the saturation current of the choke coil (210) is
- at a maximum 25%,
- at a maximum of 10%, or
- a maximum of 5%
of the filter nominal current.

5. A wind turbine according to one of the preceding claims
**characterised in that**
- the filter device (204, 206) is constructed without respective ohmic resistors (212) connected in parallel with the at least one choke coil, namely damping resistors, and in particular
- the filter device does not have any damping resistors.

6. A wind turbine according to one of the preceding claims
**characterised in that**
- the generator (200) has one or more three-phase stator systems, and
- for each three-phase stator system the filter device (204, 206) as the choke coil (210) has a three-phase choke or three single-phase chokes with a choke path per phase, and
- a capacitor is connected to each choke path,
- so that there are three capacitors for each three-phase stator system, and wherein
- said three capacitors (208) are connected in a delta or a star configuration, wherein it is particularly provided that
- the filter device (204, 206) for each three-phase stator system has as electrical components only the single-phase or three-phase choke and the three capacitors.

7. A wind turbine according to one of the preceding claims
**characterised in that**
the generator (200) is connected to a rectifier (202) for rectification of the multiphase generator current,
wherein the generator current has a plurality of phase currents with positive and negative half-waves respectively,
- the multiphase generator current is fed to the rectifier, wherein
- the rectifier for each phase current has
- a positively implemented thyristor (214) for rectification of the positive half-waves into a positive dc voltage, and
- a negatively implemented thyristor (216) for rectification of the negative half-waves into a negative dc voltage, wherein
- the positive thyristor is actuated with rising phase for switching on, and
- the negative thyristor is actuated with falling phase for switching on,
- the inductances of the choke coils (210) are so dimensioned that they can hold a current to counteract unwanted extinction of the respective thyristor by a phase current falling below a holding current, in particular in the proximity of a zero crossing of the phase current and at low generator power levels.

8. A method of designing a choke coil (210) for use in a filter device (204, 206) in a wind turbine (100) and the wind turbine includes:
- a multiphase generator (200), in particular a synchronous generator, for generating electric power, wherein the generator generates a multiphase generator current (I_{G1}, I_{G2}, I_{G3}) and wherein the generator has a generator output (201) for output of the multiphase generator current,
- a filter device (204, 206) connected to the generator output for generating a filter current (I_{F}) for influencing the generator current for reducing electric oscillations of the generator current, wherein
- the generated filter current is dependent on the generated power of the generator, and
- the filter device includes
- at least one capacitor (208) for influencing the filter current, and
- at least one choke coil (210) connected in series upstream of the capacitor for influencing the filter current, wherein
- the choke coil has a saturation current value which indicates an amplitude of the filter current, at which the choke coil has a magnetic saturation state, and wherein
- the choke coil is so designed that the saturation current value is below a predetermined filter nominal current of the filter device,
**characterized in that** the saturation current of the choke coil (210) is at a maximum 50% of the filter nominal current..

9. A method according to claim 8
**characterised in that**
the choke coil (210) has
- with a filter current below the saturation current value an inductive behaviour, and
- with a filter current above the saturation current value an ohmic behaviour.

10. A method according to claim 8 or claim 9
**characterised in that**
the choke coil (210) is so designed that it
- is adapted to have flowing therethrough a filter current greater than the saturation current value, and wherein the choke coil is adapted to have the filter nominal current permanently flowing therethrough.

11. A method according to claims 8 to 10
**characterised in that**
the saturation current of the choke coil (210) is
- at a maximum 25%,
- at a maximum of 10%, or
- a maximum of 5%
of the filter nominal current.

12. A method according to one of claims 8 to 11
**characterised in that**
- designing of the choke coil (210) additionally includes that
- iron losses of the choke coil are so selected that the filter device can be constructed without ohmic resistors respectively connected in parallel with the choke coil, namely damping resistors, in particular such that
- the filter device does not have any damping resistors.

13. A method of converting a wind turbine (100) by retrofitting of a filter device, and the wind turbine includes:
- a multiphase generator (200), in particular a synchronous generator, for generating electric power, wherein the generator generates a multiphase generator current (I_{G1}, I_{G2}, I_{G3}) and wherein the generator has a generator output for output of the multiphase generator current,
- a filter device connected to the generator output for generating a filter current (I_{F}) for influencing the generator current for reducing electric oscillations of the generator current, wherein
- the generated filter current is dependent on the generated power of the generator,
and the method includes:
- replacement of a previous filter device or a part thereof by a modified filter device or a part thereof so that the wind turbine after conversion has a modified filter device, and
- the modified filter device (204, 206) includes
- at least one capacitor (208) for influencing the filter current, and
- at least one choke coil (210) connected in series upstream of the capacitor for influencing the filter current, wherein
- the choke coil has a saturation current value which denotes an amplitude of the filter current, at which the choke coil has a magnetic saturation state, and wherein
- the saturation current value is below a predetermined filter nominal current of the filter device,
**characterized in that**
the saturation current of the choke coil (210) is at a maximum 50% of the filter nominal current..

14. A method of converting a wind turbine (100) according to claim 13
**characterised in that**
- of the previous filter device at least one filter choke or all filter chokes is or are respectively replaced by one with a lower saturation current and that in addition or optionally
- damping resistors are removed from the previous filter device, in particular in such a way that thereafter there are no longer any damping resistors in the converted filter device.

15. A method of converting a wind turbine (100) according to claim 13 or claim 14
**characterised in that**
- existing choke coils are respectively replaced by a choke coil designed in accordance with one of claims 7 to 11 and
- existing damping resistors are removed from the previous filter device.

## Revendications

1. Eolienne (100) destinée à générer une puissance électrique à injecter dans un réseau d'alimentation électrique, comprenant :
- un générateur multiphasé (200), en particulier un générateur synchrone, destiné à générer une puissance électrique, dans laquelle le générateur génère un courant de générateur multiphasé (I_{G1}, I_{G2}, I_{G3}), et dans laquelle le générateur présente une sortie de générateur (201) destinée à distribuer le courant de générateur multiphasé,
- un système de filtre (204, 206) raccordé à la sortie de générateur, destiné à générer un courant de filtre (I_{F}) pour influencer le courant de générateur pour réduire des oscillations électriques du courant de générateur, dans laquelle
- - le courant de filtre généré dépend de la puissance générée du générateur, et
- - le système de filtre comprend
- - - au moins une capacité (208) destinée à influencer le courant de filtre, et
- - - au moins une bobine de réactance (210) montée en série en amont de la capacité, destinée à influencer le courant de filtre, dans laquelle
- - - - la bobine de réactance présente une valeur de courant de saturation, qui désigne une amplitude du courant de filtre, à laquelle la bobine de réactance présente un état de saturation magnétique, et dans laquelle
la valeur de courant de saturation est inférieure à un courant nominal de filtre prédéfini, **caractérisée en ce que** le courant de saturation de la bobine de réactance (210) est de 50 % au maximum du courant nominal de filtre.

2. Eolienne selon la revendication 1,
**caractérisée en ce que**
la bobine de réactance (210) présente
- un comportement inductif pour un courant de filtre inférieur à la valeur de courant de saturation, et
- un comportement ohmique pour un courant de filtre supérieur à la valeur de courant de saturation.

3. Eolienne selon la revendication 1 ou 2,
**caractérisée en ce que**
- la bobine de réactance (210) est mise au point pour être traversée par un courant de filtre qui est supérieur à la valeur de courant de saturation, dans laquelle la bobine de réactance est mise au point pour être traversée durablement par le courant nominal de filtre.

4. Eolienne selon la revendication 1,
**caractérisée en ce que**
le courant de saturation de la bobine de réactance (210) est
- de 25 % au maximum ;
- de 10 % au maximum ; ou
- de 5 % au maximum
du courant nominal de filtre.

5. Eolienne selon l'une quelconque des revendications précédentes,
**caractérisée en ce que**
- le système de filtre (204, 206) est élaboré sans résistances (212) ohmiques branchées en parallèle respectivement par rapport à l'au moins une bobine de réactance, à savoir des résistances d'amortissement, en particulier que
- le système de filtre ne présente aucune résistance d'amortissement.

6. Eolienne selon l'une quelconque des revendications précédentes,
**caractérisée en ce que**
- le générateur (200) présente un ou plusieurs systèmes de stator triphasés, et
- le système de filtre (204, 206) présente, par rapport à chaque système de stator triphasé, en tant que bobine de réactance (210), une bobine triphasée ou trois bobines monophasées avec un chemin de bobine par phase, et
- un condensateur est raccordé à chaque chemin de bobine,
- si bien que trois condensateurs sont prévus pour chaque système de stator triphasé, et dans laquelle
- ces trois condensateurs (208) sont interconnectés en un triangle ou une étoile, dans laquelle il est prévu en particulier que
- le système de filtre (204, 206) présente pour chaque système de stator triphasé en tant que composants électriques seulement la bobine mono- ou triphasée et les trois condensateurs.

7. Eolienne selon l'une quelconque des revendications précédentes,
**caractérisée en ce que**
le générateur (200) est relié à un redresseur (202) destiné à redresser le courant de générateur multiphasé,
dans laquelle le courant de générateur présente plusieurs courants de phase respectivement avec des demi-ondes positives et négatives,
- le courant de générateur multiphasé est amené au redresseur, dans laquelle
- le redresseur présente pour chaque courant de phase
- - un thyristor (214) utilisé en mode positif destiné à redresser les demi-ondes positives en une tension continue positive, et
- - un thyristor utilisé en mode négatif (216) destiné à redresser les demi-ondes négatives en une tension continue négative, dans laquelle
- - le thyristor utilisé en mode positif est piloté pour la mise en service en cas de hausse de la phase, et
- - le thyristor utilisé en mode négatif est piloté pour la mise en service en cas de baisse de la phase
- les inductances des bobines de réactance (210) sont dimensionnées de telle sorte qu'elles peuvent maintenir un courant pour contrecarrer une suppression involontaire du thyristor respectif par un courant de phase baissant sous un courant de maintien, en particulier à proximité d'un passage par zéro du courant de phase et en présence de faibles puissances de générateur.

8. Procédé de conception d'une bobine de réactance (210) destinée à être utilisée dans un système de filtre (204, 206) dans une éolienne (100), laquelle éolienne comprend
- un générateur multiphasé (200), en particulier un générateur synchrone, destiné à générer une puissance électrique, dans lequel le générateur génère un courant de générateur multiphasé (I_{G1}, I_{G2}, I_{G3}), et dans lequel le générateur présente une sortie de générateur (201) destinée à distribuer le courant de générateur multiphasé,
- un système de filtre (204, 206) raccordé à la sortie de générateur, destiné à générer un courant de filtre (I_{F}) pour influencer le courant de générateur pour réduire des oscillations électriques du courant de générateur, dans lequel
- - le courant de filtre généré dépend de la puissance générée du générateur, et
- - le système de filtre comprend
- - - au moins une capacité (208) destinée à influencer le courant de filtre, et
- - - au moins une bobine de réactance (210) montée en série en amont de la capacité, destinée à influencer le courant de filtre, dans lequel
- - - - la bobine de réactance présente une valeur de courant de saturation, qui désigne une amplitude du courant de filtre, à laquelle la bobine de réactance présente un état de saturation magnétique, et dans lequel
la bobine de réactance est conçue de telle sorte que la valeur de courant de saturation est inférieure à un courant nominal de filtre prédéfini, **caractérisé en ce que** le courant de saturation de la bobine de réactance (210) est de 50 % au maximum du courant nominal de filtre.

9. Procédé selon la revendication 8,
**caractérisé en ce que**
la bobine de réactance (210) est conçue de telle sorte que celle-ci
- présente un comportement inductif pour un courant de filtre inférieur à la valeur de courant de saturation, et
- présente un comportement ohmique pour un courant de filtre supérieur à la valeur de courant de saturation.

10. Procédé selon la revendication 8 ou 9,
**caractérisé en ce que**
la bobine de réactance (210) est conçue de telle sorte que celle-ci
- est mise au point pour être traversée par un courant de filtre qui est supérieur à la valeur de courant de saturation, dans lequel la bobine de réactance est mise au point pour être traversée durablement par le courant nominal de filtre.

11. Procédé selon la revendication 8 à 10,
**caractérisé en ce que**
le courant de saturation de la bobine de réactance (210) est
- de 25 % au maximum ;
- de 10 % au maximum ; ou
- de 5 % au maximum
du courant nominal de filtre.

12. Procédé selon l'une quelconque des revendications 8 à 11,
**caractérisé en ce que**
- la conception de la bobine de réactance (210) comprend en supplément que
- des pertes fer de la bobine de réactance sont choisies de telle sorte que le système de filtre peut être élaboré sans résistances ohmiques branchées en parallèle respectivement par rapport à la bobine de réactance, à savoir des résistances d'amortissement, en particulier de telle sorte que
- le système de filtre ne présente aucune résistance d'amortissement.

13. Procédé de rééquipement d'une éolienne (100), par rééquipement d'un système de filtre, laquelle éolienne comprend
- un générateur multiphasé (200), en particulier un générateur synchrone, destiné à générer une puissance électrique, dans lequel le générateur génère un courant de générateur multiphasé (I_{G1}, I_{G2}, I_{G3}), et dans lequel le générateur présente une sortie de générateur destinée à distribuer le courant de générateur multiphasé,
- un système de filtre raccordé à la sortie de générateur, destiné à générer un courant de filtre (I_{F}) pour influencer le courant de générateur pour réduire des oscillations électriques du courant de générateur, dans lequel
- - le courant de filtre généré dépend de la puissance générée du générateur,
et le procédé comprend :
- le remplacement d'un système de filtre utilisé jusqu'à présent ou d'une partie de celui-ci par un système de filtre modifié ou une partie de celui-ci de sorte que l'éolienne présente après le rééquipement un système de filtre modifié, et
- le système de filtre (204, 206) modifié comprend
- au moins une capacité (208) destinée à influencer le courant de filtre, et
- au moins une bobine de réactance (210), branchée en série en amont de la capacité, destinée à influencer le courant de filtre, dans lequel
- la bobine de réactance présente une valeur de courant de saturation, qui désigne une amplitude du courant de filtre, à laquelle la bobine de réactance présente un état de saturation magnétique, et dans lequel
- la valeur de courant de saturation est inférieure à un courant nominal de filtre prédéfini du système de filtre,
**caractérisé en ce que** le courant de saturation de la bobine de réactance (210) est de 50 % au maximum du courant nominal de filtre.

14. Procédé de rééquipement de l'éolienne (100) selon la revendication 13,
**caractérisé en ce que**
- au moins une bobine de filtre ou toutes les bobines de filtre sont remplacées par le système de filtre utilisé jusqu'à présent respectivement par une bobine avec un courant de saturation faible, et que par ailleurs ou en option
- des résistances d'amortissement sont retirées du système de filtre utilisé jusqu'à présent, en particulier de telle sorte qu'ensuite aucune résistance d'amortissement n'est plus présente dans le système de filtre rééquipé.

15. Procédé de rééquipement de l'éolienne (100) selon la revendication 13 ou 14,
**caractérisé en ce que**
- des bobines de réactance présentes sont remplacées respectivement par une bobine de réactance conçue selon l'une quelconque des revendications 7 à 11, et que
- des résistances d'amortissement présentes sont retirées du système de filtre utilisé jusqu'à présent.
